# EUROPÄISCHE PATENTSCHRIFT

(11) **EP 0 710 988 B1**
(45) Veröffentlichungstag und Bekanntmachung des Hinweises auf die Patenterteilung: **08.10.1997**
(21) Anmeldenummer: 95117277.4
(22) Anmeldetag: 02.11.1995
(51) Int. Cl.: H01L 29/10, H01L 21/331, H01L 21/336

(54) **Verfahren zum Herstellen von durch Feldeffekt steuerbaren Halbleiterbauelementen**
Manufacturing method for semiconductor devices controlled by field effect
Procédé pour la fabrication des dispositifs semiconducteurs controlables par effet de champ

(30) Priorität: 04.11.1994 DE 4439531
(43) Veröffentlichungstag der Anmeldung: 08.05.1996
(73) Patentinhaber: SIEMENS AKTIENGESELLSCHAFT, 80333 München (DE)
(72) Erfinder: Hertrich, Helmut, Dipl.-Ing., D-85777 Fahrenzhausen (DE); Strack, Helmut, Dr., D-80804 München (DE); Tihanyi, Jenoe, Dr., D-85551 Kirchheim (DE)

(56) Entgegenhaltungen:
- DE-A- 3 435 612
- DE-A- 3 447 220
- PATENT ABSTRACTS OF JAPAN vol. 14 no. 16 (E-872) ,12.Januar 1989 & JP-A-01 258473 (FUJI ELECTRIC) 16.Oktober 1989,

## Beschreibung

Verfahren zum Herstellen von durch Feldeffekt steuerbaren Halbleiterbauelementen

Die Erfindung bezieht sich auf ein Verfahren zum Herstellen eines durch Feldeffekt steuerbaren Halbleiterbauelementes.

Solche Halbleiterbauelemente können z.B. Leistungs-MOSFET oder IGBT sein. Ein beiden Typen von Leistungs-Halbleiterbauelementen gemeinsames Problem besteht darin, daß in der Drainzone bzw. Innenzone erzeugte Minoritätsladungsträger bei Überlastung des Halbleiterbauelementes am pn-Übergang zwischen Sourcezone und Basiszone einen so hohen Spannungsabfall erzeugen können, daß parasitäre Bipolarstrukturen eingeschaltet werden. Geschieht dies, so steigt der Strom im Halbleiterbauelement weiter stark an und das Halbleiterbauelement wird durch sekundären Break-down zerstört.

Aus der DE 34 35 612 ist eine Oberflächen-Halbleitervorrichtung sowie ein Verfahren zu ihrer Herstellung bekannt, welches einen implantierten Kurzschlußbereich, der sowohl an Basis als auch Sourcebereichen angrenzt, wobei der implantierte Kurzschlußbereich leitend mit der Source-Elektrode verbunden ist, um so einen Basis-Source-Elektrodenkurzschluß zu implementieren, bekannt. Der dort implementierte Kurzschlußbereich kann ohne eine speziell ausgerichtete Maske gebildet werden, imdem die Gate-Elektrode als eine Implantierungsmaske verwendet wird.

Aus der DE 34 47 220 ist ein abschaltbarer Thyristor mit verbessertem Emitter-Bereich und ein Verfahren zu seiner Herstellung bekannt. Der dort beschriebene Thyristor umfaßt eine Anzahl von Hauptemitterteilen, die zueinander parallel und schwächer dotiert sind, sowie Kanalemitterteile, die quer zu den Hauptemitterteilen orientiert sind. Dadurch wird die Anzahl der Abschaltkanäle erhöht, wodurch der Wert des Stroms, der durch den Thyristor ausgeschaltet werden kann, erhöht wird. Ferner ist dort ein Basisbereich mit einer Schicht erhöhter Leitfähigkeit relativ zur Oberfläche der Basisregion vorgesehen, der den Wert des Vorrichtungsstroms erhöht, der durch den Thyristor ausgeschaltet werden kann.

Schließlich ist aus der JP-A-01 258 473 ein MOSFET bekannt, bei dem zur Vermeidung des Einschaltens parasitärer Bipolarstrukturen eine stark p-dotierte Schicht als Kurzschlußbereich vorgeschlagen wird.

Der Erfindung liegt die Aufgabe zugrunde, ein Verfahren zum Herstellen der beschriebenen Halbleiterbauelemente anzugeben, mit dem es möglich ist, ihren Aufbau derart zu gestalten, daß der erwähnte sekundäre Break-down vermieden wird.

Diese Aufgabe wird durch zwei Alternativen gemäß den Kennzeichen der Ansprüche 1 und 2 gelost.

Weiterbildungen der Erfindung sind Gegenstand der Unteransprüche.

Die Erfindung wird anhand zweier Ausführungsbeispiele in Verbindung mit den Figuren 1, 2 und 3 näher erläutert. Dabei zeigt
- Figur 1: den Zustand nach einem charakteristischen Verfahrensschritt eines ersten Ausführungsbeispiels,
- Figur 2: den Schnitt durch ein fertiges Halbleiterbauelement gemäß dem ersten Ausführungsbeispiel und
- Figur 3: den Schnitt durch ein fertiges Halbleiterbauelement gemäß einem zweiten Ausführungsbeispiel.

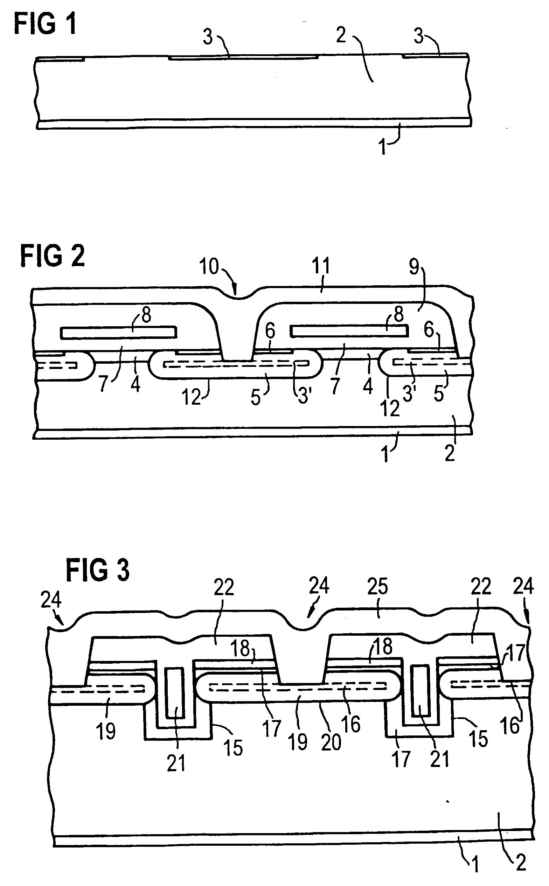

Das Halbleiterbauelement nach Figur 1 und 2 basiert auf einem Substrat 1, auf dem eine erste aus Halbleitermaterial bestehende Schicht 2 aufgebracht ist. Diese Schicht kann epitaktisch auf dem Substrat 1 abgeschieden sein. Die Schicht 2 kann jedoch auch eine von einem Halbleiterstab abgeschnittene Scheibe sein, in die auf der Unterseite durch Implantation oder Diffusion Dotierstoffe eingebracht werden, die dann das Substrat 1 bilden. Die Schicht 2 bildet einen Teil der Drainzone des zu erzeugenden Halbleiterbauelementes. Ihre Dicke kann zwischen 5 und 100 µm liegen.

In der Oberseite der Schicht 2 werden durch Implantation von Dotierstoffen Zonen 3 vom zweiten Leitungstyp erzeugt. Die Dotierstoffe können z.B. durch eine strukturierte Maske eines abgeschiedenen Oxids oder eines strukturierten lokal aufgewachsenen Oxids in die Oberfläche der ersten Schicht 2 implantiert werden. Als Dosis ist z.B. ≥ 10¹⁵ cm⁻² Bor geeignet.

Als nächstes wird auf die ganze Oberfläche, also auf die freie Oberfläche der ersten Schicht 2 und die Oberfläche der Zonen 3 epitaktisch Halbleitermaterial des ersten Leitungstyps abgeschieden. Dabei entsteht eine zweite Schicht 4 (Figur 2) mit einer Dicke von z.B. 0,1 bis 5 µm. Die Schichten 2 und 4 bilden zusammen die Drainzone des Halbleiterbauelements. Die Dotierungskonzentration der zweiten Schicht 4 kann der der ersten Schicht 2 entsprechen, sie kann jedoch auch größer sein. Das epitaktische Abscheiden der zweiten Schicht 4 geschieht im allgemeinen bei einer Temperatur zwischen 900 und 1000° C. Dabei diffundieren die Dotierstoffe des zweiten Leitungstyps aus der Zone 3 allseitig aus. Dabei entstehen Basiszonen 5. Das Maximum der Dotierstoffkonzentration liegt dabei am Ort der ursprünglichen implantierten Zonen 3. Die Dotierstoffmaxima sind in Figur 2 gestrichelt eingezeichnet und mit 3' bezeichnet. Zur Oberfläche des Halbleiterkörpers, d.h. zur Oberfläche der zweiten Schicht 4 nimmt ausgehend von 3' die Dotierungskonzentration der Basiszonen 5 ebenso ab wie seitlich und in Richtung des Substrats 1. Der pn-Übergang zwischen den Basiszonen 5 und der Drainzone 2, 4 ist mit 12 bezeichnet. Durch die relativ geringe Dotierung an der Oberfläche kann die Einsatzspannung niedrig gehalten werden.

Die Oberfläche des Halbleiterkörpers wird dann mit einer Oxidschicht 7 bedeckt, auf der eine Polysiliziumschicht abgeschieden wird. Diese Polysiliziumschicht wird strukturiert und bildet die Gateelektrode 8. Anschließend wird in die Oberfläche der Basiszonen 5 unter Verwendung der Gateelektrode als Maske Dotierstoffe des ersten Leitungstyps implantiert, die die Sourcezonen 6 bilden.

Nach Abscheidung einer weiteren Oxidschicht 9 auf der Gateelektrode werden im Bereich der Sourcezonen 6 und der Basiszonen 5 Kontaktöffnungen 10 erzeugt. Diese Kontaktöffnungen gehen durch die Sourcezonen 6, bis zum Dotierstoffmaximum 3' der Basiszonen 5. Dieses Dotierstoffmaximum überragt die Sourcezonen 6 in lateraler Richtung und reicht bis unter die Gateelektroden 8. Auf der Oberfläche der zweiten Oxidschicht 9 wird nun eine Metallschicht 11 abgeschieden, die sowohl die Sourcezonen 6 kontaktiert als auch die Basiszonen 5. Durch die große laterale Ausdehnung des Dotierstoffmaximums werden nun aus der Schicht 2 stammende Minoritätsladungsträger eingefangen und gelangen zur Sourceelektrode 11. Durch die hohe Leitfähigkeit der Zone 3 reicht der Spannungsabfall am pn-Übergang zwischen den Sourcezonen 6 und den Basiszonen 5 nicht aus, um die zur Emission von Ladungsträgern notwendigen 0,5 Volt zu erzielen.

Das Halbleiterbauelement nach Figur 3 unterscheidet sich von dem nach Figur 2 hauptsächlich dadurch, daß die erste Schicht 2 mit Gräben 15 versehen ist, in denen isoliert vertikale Gateelektroden 21 angeordnet sind. Das Halbleiterbauelement nach Figur 3 wird derart hergestellt, daß vor Erzeugung der Gräben in die gesamte Oberfläche der ersten Schicht 2 Dotierstoffe des zweiten Leitungstyps implantiert werden. Diese bilden eine Schicht 16. Anschließend werden die Gräben 15 erzeugt, hier wird die Schicht 16 entfernt. Sodann wird epitaktisch eine zweite Schicht 17 abgeschieden, die sich auf die gesamte Oberfläche des Halbleiterkörpers einschließlich der Wände der Gräben legt. Beim epitaktischen Aufwachsen diffundieren die in der Schicht 16 enthaltenen Dotierstoffe sowohl in die erste Schicht 2 als auch in die zweite Schicht 17. Sie dotieren auch einen Teil der an den Wänden der Gräben 15 abgeschiedenen zweiten Schicht 17 um. Durch die Diffusion der Dotierstoffe aus den Zonen 16 werden Basiszonen 19 erzeugt, die bis an die Seitenwände der Gräben reichen. Eine Diffusion bis zur horizontalen Oberfläche der zweiten Schicht ist nicht notwendig, schadet im allgemeinen jedoch nicht.

In die Oberfläche der zweiten Schicht 17 außerhalb der Gräben werden nun Dotierstoffe des ersten Leitungstyps implantiert, die Sourcezonen 18 bilden. Eine Implantation in die in die Gräben reichenden zweiten Schicht 17 wird durch entsprechende Maskierung verhindert.

Nach Abscheiden einer ersten Oxidschicht auf den Zonen 18 und in den Gräben 15 werden die Gateelektroden 21 in den Gräben erzeugt. Anschließend werden die Gateelektroden 21 durch eine weitere Oxidschicht bedeckt. Beide Oxidschichten sind der Einfachheit halber mit einer einzigen Bezugsziffer 22 bezeichnet. Die Oxidschicht 22 wird dann im Bereich der Sourcezonen 18 und der Basiszonen 19 mit Kontaktöffnungen 24 versehen. Diese reichen wie im Ausführungsbeispiel nach Figur 2 bis zum Maximum 16 der Dotierstoffkonzentration der Basiszonen 19. Der pn-Übergang zwischen den Basiszonen 19 und der Drainzone ist mit 20 bezeichnet. Nach Erzeugung der Kontaktöffnungen 24 wird auf die ganze Oberfläche eine Metallschicht 25 aufgebracht, die die Sourcezonen kontaktiert und die Basiszonen 19 an ihrem Dotierstoffmaximum 16.

Das Dotierstoffmaximum der Basiszone 19 reicht hier von Graben zu Graben. Aus dem Inneren des Halbleiterkörpers stammende Minoritätsladungsträger werden daher durch die hochdotierte Zone 16 fast ebenso wirkungsvoll eingefangen und zur Sourceelektrode 25 abgeleitet wie im Ausführungsbeispiel nach Figur 2.

Das Substrat 1 hat bei einem Leistungs-MOSFET den gleichen Leitungstyp wie die Drainzone 2, 4, ist jedoch wesentlich höher dotiert als diese. Bei einem IGBT hat das Substrat 1 den der Zone 2 entgegengesetzten Leitungstyp.

Die Basiszonen und die Sourcezonen sind vorzugsweise zellenförmig ausgebildet. Sollte die Temperatur, bei der epitaktisch abgeschieden wird, zur Erzeugung der Basiszonen nicht ausreichen, so kann anschließend mit höherer Temperatur nachdiffundiert werden. Zur Einstellung der Einsatzspannung können nach Erzeugung der Basiszonen und Sourcezonen in die Oberfläche des Halbleiterkörpers ganzflächig weitere Dotierstoffe implantiert werden.

## Patentansprüche

1. Verfahren zum Herstellen eines durch Feldeffekt steuerbaren Halbleiterbauelementes,
**gekennzeichnet durch**
die Schritte:
a) In der Oberfläche einer ersten Schicht (2) vom ersten Leitungstyp werden durch Implantation von Dotierstoffen Zonen (3) vom zweiten Leitungstyp erzeugt,
b) auf der ersten Schicht (2) und den Zonen (3) vom zweiten Leitungstyp wird eine zweite Schicht vom ersten Leitungstyp epitaktisch abgeschieden, wodurch unter allseitiger Diffusion von Dotierstoffen aus den Zonen (3) vom zweiten Leitungstyp Basiszonen (5) erzeugt werden, welche sich bis zur Oberfläche der zweiten Schicht erstrecken,
c) in der Oberfläche der zweiten Schicht werden in den Basiszonen Sourcezonen (6) vom ersten Leitungstyp erzeugt,
d) die Basiszonen des zweiten Leitungstyps erhalten solche lateralen Abmessungen, daß deren Dotierstoffmaximum (3') lateral sich mindestens über die Sourcezonen erstreckt,
e) in den Sourcezonen und den Basiszonen werden Kontaktöffnungen erzeugt, die bis zum Dotierstoffmaximum der Basiszonen reicht,
f) die Sourcezonen und die Basiszonen werden durch eine in die Kontaktöffnungen reichende Metallschicht elektrisch miteinander verbunden.

2. Verfahren zum Herstellen eines durch Feldeffekt steuerbaren Halbleiterbauelementes,
**gekennzeichnet durch**
die Schritte:
a) In der Oberfläche einer ersten Schicht (2) vom ersten Leitungstyp wird durch Implantation von Dotierstoffen eine Zone vom zweiten Leitungstyp erzeugt,
b) in der Oberfläche der ersten Schicht werden zur Aufnahme von vertikalen Gateelektroden (21) bestimmte Gräben (15) erzeugt, wodurch eine Vielzahl von Zonen (19) des zweiten Leitungstyps entsteht,
c) auf den Zonen des zweiten Leitungstyps und an den Wänden der Gräben wird eine zweite Schicht (17) vom ersten Leitungstyp epitaktisch abgeschieden, wodurch unter allseitiger Diffusion von Dotierstoffen aus den Zonen des zweiten Leitungstyps Basiszonen (19) erzeugt werden,
d) die Basiszonen des zweiten Leitungstyps erhalten solche Abmessungen, daß ihre Dotierstoffe in den Seitenwänden der Gräben bis an die Oberfläche der zweiten Schicht reichen,
e) in der zweiten Schicht werden an der Oberfläche des Halbleiterkörpers Sourcezonen erzeugt,
f) in den Sourcezonen und in der zweiten Schicht an der Oberfläche des Halbleiterkörpers werden Kontaktöffnungen erzeugt, die bis zum Dotierstoffmaximum der Basiszonen des zweiten Leitungstyps reichen,
g) die Sourcezonen und die Basiszonen des zweiten Leitungstyps werden durch eine in die Kontaktöffnungen reichende Metallschicht elektrisch miteinander verbunden.

3. Verfahren nach Anspruch 1 oder 2,
**dadurch gekennzeichnet**, daß die Sourcezonen durch Implantation von Dotierstoffen erzeugt werden.

4. Verfahren nach einem der Ansprüche 1 bis 3,
**dadurch gekennzeichnet**, daß in die Oberfläche des Halbleiterkörpers nach dem epitaktischen Abscheiden der zweiten Schicht und dem Erzeugen der Sourcezonen und Basiszonen ganzflächig Dotierstoffe implantiert werden.

5. Verfahren nach einem der Ansprüche 1 bis 4,
**dadurch gekennzeichnet**, daß die Basiszonen und die Sourcezonen zellenförmig ausgebildet werden.

6. Verfahren nach einem der Ansprüche 1 bis 5,
**dadurch gekennzeichnet**, daß anschließend an das epitaktische Abscheiden der zweiten Schicht das Halbleiterbauelement einer höheren Temperatur ausgesetzt wird als diejenige Temperatur, bei der die zweite Schicht epitaktisch abgeschieden wurde.

## Claims

1. Method for producing a field-effect-controllable semiconductor component, characterized by the steps:
a) zones (3) of the second conduction type are produced in the surface of a first layer (2) of the first conduction type by implantation of dopants,
b) a second layer of the first conduction type is epitaxially deposited on the first layer (2) and the zones (3) of the second conduction type, as a result of which, with the diffusion of dopants from all sides of the zones (3) of the second conduction type, base zones (5) are produced which extend up to the surface of the second layer,
c) source zones (6) of the first conduction type are produced in the base zones in the surface of the second layer,
d) the base zones of the second conduction type are given lateral dimensions such that their dopant maximum (3') extends laterally at least over the source zones,
e) contact openings which reach down to the dopant maximum of the base zones are produced in the source zones and the base zones,
f) the source zones and the base zones are electrically connected to one another by a metal layer reaching into the contact openings.

2. Method for producing a field-effect-controllable semiconductor component, characterized by the steps:
a) a zone of the second conduction type is produced in the surface of a first layer (2) of the first conduction type by implantation of dopants,
b) trenches (15) which are intended to receive vertical gate electrodes (21) are produced in the surface of the first layer, thereby producing a multiplicity of zones (19) of the second conduction type,
c) a second layer (17) of the first conduction type is epitaxially deposited on the zones of the second conduction type and on the walls of the trenches, as a result of which, with diffusion of dopants from all sides of the zones of the second conduction type, base zones (19) are produced,
d) the base zones of the second conduction type are given dimensions such that their dopants in the side walls of the trenches reach as far as the surface of the second layer,
e) source zones are produced in the second layer on the surface of the semiconductor body,
f) contact openings which reach down to the dopant maximum of the base zones of the second conduction type are produced in the source zones and in the second layer on the surface of the semiconductor body,
g) the source zones and the base zones of the second conduction type are electrically connected to one another by a metal layer reaching into the contact openings.

3. Method according to Claim 1 or 2, characterized in that the source zones are produced by implantation of dopants.

4. Method according to one of Claims 1 to 3, characterized in that dopants are implanted over the whole area into the surface of the semiconductor body after the epitaxial deposition of the second layer and the production of the source zones and base zones.

5. Method according to one of Claims 1 to 4, characterized in that the base zones and the source zones are designed in the form of cells.

6. Method according to one of Claims 1 to 5, characterized in that, following the epitaxial deposition of the second layer, the semiconductor component is exposed to a higher temperature than that temperature at which the second layer was epitaxially deposited.

## Revendications

1. Procédé de fabrication d'un dispositif semi-conducteur contrôlable par effet de champ, caractérisé par les étapes :
a) dans la surface d'une première couche (2) du premier type de conductibilité, on fabrique des zones (3) du deuxième type de conductibilité par implantation d'agents de dopage,
b) une seconde couche du premier type de conductibilité est déposée par épitaxie sur la première couche (2) et les zones (3) du deuxième type de conductibilité, grâce à quoi des zones de base (5) s'étendant jusqu'à la surface de la seconde couche sont produites sous l'effet de la diffusion dans tous les sens d'agents de dopage provenant des zones (3) du deuxième type de conductibilité,
c) des zones de source (6) du premier type de conductibilité sont fabriquées dans les zones de base, dans la surface de la seconde couche,
d) les zones de base du deuxième type de conductibilité ont des dimensions latérales telles que leur maximum de concentration en agents de dopage (3') s'étend, dans le sens latéral, au moins sur les zones de source,
e) des ouvertures de contact allant jusqu'au maximum de concentration en agents de dopage des zones de base sont fabriquées dans les zones de source et les zones de base,
f) les zones de source et les zones de base sont reliées électriquement les unes aux autres par une couche métallique qui entre dans les ouvertures de contact.

2. Procédé de fabrication d'un dispositif semi-conducteur contrôlable par effet de champ, caractérisé par les étapes :
a) dans la surface d'une première couche (2) du premier type de conductibilité, on fabrique une zone du deuxième type de conductibilité par implantation d'agents de dopage,
b) dans la surface de la première couche, on fabrique des fosses (15) destinées à recevoir des électrodes de commande (21) verticales, grâce à quoi une pluralité de zones (19) du deuxième type de conductibilité sont créées,
c) une seconde couche (17) du premier type de conductibilité est déposée par épitaxie sur les zones du deuxième type de conductibilité et sur les parois des fosses, grâce à quoi des zones de base (19) sont fabriquées sous l'effet de la diffusion dans tous les sens d'agents de dopage provenant des zones du deuxième type de conductibilité,
d) les zones de base du deuxième type de conductibilité ont des dimensions telles que leurs agents de dopage arrivent dans les parois latérales des fosses et jusqu'à la surface de la seconde couche,
e) des zones de source sont fabriquées à la surface du corps semi-conducteur dans la seconde couche,
f) des ouvertures de contact qui vont jusqu'au maximum de concentration en agents de dopage des zones de base du deuxième type de conductibilité sont fabriquées à la surface du corps semi-conducteur, dans les zones de source et dans la seconde couche,
g) les zones de source et les zones de base du deuxième type de conductibilité sont reliées électriquement les unes aux autres par une couche métallique qui entre dans les ouvertures de contact.

3. Procédé selon la revendication 1 ou 2, caractérisé en ce que les zones de source sont fabriquées par implantation d'agents de dopage.

4. Procédé selon l'une des revendications 1 à 3, caractérisé en ce que, après le dépôt par épitaxie de la seconde couche et la fabrication des zones de source et des zones de base, des agents de dopage sont implantés dans la totalité de la surface du corps semi-conducteur.

5. Procédé selon l'une des revendications 1 à 4, caractérisé en ce que les zones de base et les zones de source sont exécutées de manière à avoir la forme de cellules.

6. Procédé selon l'une des revendications 1 à 5, caractérisé en ce que, après le dépôt par épitaxie de la seconde couche, le dispositif semi-conducteur est soumis à une température plus élevée que la température à laquelle la seconde couche a été déposée par épitaxie.
